# EUROPEAN PATENT SPECIFICATION

(11) **EP 1 246 239 B1**
(45) Date of publication and mention of the grant of the patent: **23.07.2008**
(21) Application number: 02007149.4
(22) Date of filing: 28.03.2002
(51) Int. Cl.: H01L 21/768

(54) **Method of forming dual damascene structure**
Verfahren zum Herstellen einer Dual-Damascene-Struktur
Methode de fabrication d'une structure dual-damascene

(30) Priority: 30.03.2001 JP 2001101186
(43) Date of publication of application: 02.10.2002
(73) Proprietor: JSR Corporation, Tokyo 104-0045 (JP)
(72) Inventor: Shiota, Atsushi, Ushiku City, Ibaraki (JP)
(74) Representative: TBK-Patent

(56) References cited:
- WO-A-00/75988
- WO-A-01/18861
- WO-A-99/43025
- HASEGAWA T ET AL: "COPPER DUAL DAMASCENE INTERCONNECTS WITH LOW-K (KOFF < 3.0) DIELECTRICS USING FLARETM AND AN ORGANO-SILICATE HARD MASK" INTERNATIONAL ELECTRON DEVICES MEETING 1999. IEDM. TECHNICAL DIGEST. WASHINGTON, DC, DEC. 5 - 8, 1999, NEW YORK, NY: IEEE, US, 1 August 2000 (2000-08-01), pages 623-626, XP000933258 ISBN: 0-7803-5411-7
- PATENT ABSTRACTS OF JAPAN vol. 2000, no. 06, 22 September 2000 (2000-09-22) -& JP 2000 082741 A (INTERNATL BUSINESS MACH CORP <IBM>), 21 March 2000 (2000-03-21) -& US 2001/022398 A1 20 September 2001 (2001-09-20)

## Description

### FIELD OF THE INVENTION

The present invention relates to a method of wiring for semiconductor devices. More particularly, the invention relates to method of forming a dual damascene structure suitable for wiring on semiconductors.

### DESCRIPTION OF THE RELATED ART

With the trend toward size reduction in semiconductor devices, the shifting of the wiring material from aluminum, which has been used hitherto, to copper is progressing. In the case of using copper as an interconnect material, damascene methods are frequently used. Of these methods, the dual damascene method, by which a via-post and trench line can be simultaneously formed, is regarded as a preferred technique because it is effective in reducing the semiconductor device production cost.

The technique of forming a copper wiring by the dual damascene method is presently spreading and coming to be generally used for forming interconnect structures containing SiO₂ as dielectrics.

The desire for further size reduction in semiconductor devices has lead to investigations not only on wiring materials but on dielectrics. Specifically, investigations are being made enthusiastically on shifting from silica (dielectric constant, 4), which is in current use, to a material having a lower dielectric constant.

Examples of such a low dielectric constant material include fluorine-doped silica obtained by adding fluorine atoms to ordinary silica, carbon-containing silica film formed by CVD, organic dielectric films formed from a coating fluid, and siloxane films formed from a coating fluid.

On the other hand, a dual damascene can be formed by several methods. Examples thereof include the via-first method, trench-first method, buried hardmask method, and dual hardmask method.

In the case of using conventional silica or fluorine-doped silica as dielectrics, the via-first method is exclusively employed from the standpoints of the ease of mask alignment and the total number of steps. In the via-first method, a via pattern is first formed in an dielectric film and the via formed is then filled with a photoresist or antireflection material to form a trench. Thereafter, the residue of the photoresist or antireflection material with which the via is filled up is removed with, e.g., an oxygen plasma or a wet stripping liquid based on a strong amine.

Because of these steps, the via-first method has a problem that the low dielectric constant film is unavoidably damaged by the plasma or potent wet stripping liquid used for removing the residue of the resist or antireflection film filling the via. The trench-first method has the same problem.

The buried hardmask method is free from the problem described above. However, it has a problem that the production cost is high because the substrate need to shuttle many times between a film deposition step and a lithographic step.

In this respect, the dual layer hardmasks method is regarded as a method which compensates for those drawbacks and is effective in the formation of a dual damascene containing a low dielectric constant material as an dielectric film.

A technique which is being investigated for forming a dual damascene by the dual layer hardmasks method employs a combination of two CVD films selected from silicon carbide, silicon nitride, and silica films. However, this technique has a problem that since all these films are silicon-containing films, it is difficult to secure a sufficient etching selective ratio between the layers to form a dual damascene structure having a satisfactory shape.

This technique further has a drawback that when it is used in combination with film formation from a coating material, a silicon wafer shuttles between the coating apparatus for film formation from a coating fluid and the CVD apparatus, making the process flow complicated.

WO 00 75988 A discloses processes for the formation of integrated circuits with multiple low dielectric-constant inter-metal dielectrics. The processes use two or more dissimilar low-k dielectrics for the inter-metal dielectrics of Cu-based dual damascene backends of integrated circuits. An integrated circuit structure is formed having a substrate; an inorganic layer on the substrate which is composed of a pattern of metal lines on the substrate and an inorganic dielectric on the substrate between the metal lines; and an organic layer on the inorganic layer which is composed of an organic dielectric having metal filled vias therethrough which connect to the metal lines of the inorganic layer.

In "Copper Dual Damascene Interconnects with Low-k (Keff<3.0) Dielectrics Using FLARE™ and an Organo-Silicate Hardmask", International Electron Devices Meeting 1999, IEDM. Technical Digest. Washington DC, Dec. 5-8, 1999, New York, NY, Hasegawa et al. disclose Cu dual damascene interconnects with low-K that use organic material (FLARE^{™}) and methyl-silsesquioxane.

### SUMMARY OF THE INVENTION

An object of the invention is to provide a novel method of forming a dual damascene structure in order to overcome the problems described above.

The invention provides a method of forming a dual damascene structure as defined in claim 1.

### BRIEF DESCRIPTION OF THE DRAWINGS

The foregoing and other aims and advantages of the invention will be apparent from the following detailed description and the accompanying drawings, in which:
Fig. 1 illustrates a multilayer structure which is not covered by the claims having an inorganic dielectric film, an organic dielectric film and a metal oxide film; and
Fig. 2 illustrates a multilayer structure having an inorganic dielectric film containing a mid etch stopper layer therein.

### DETAILED DESCRIPTION OF THE INVENTION

### Inorganic Dielectric Film

The inorganic dielectric film in the invention preferably comprises silica or a polysiloxane having hydrocarbon groups.

Although this inorganic dielectric film comprising silica or a polysiloxane having hydrocarbon groups can be formed by CVD, it is preferably formed from a coating fluid.

The coating fluid for forming the inorganic dielectric film comprises (A) a polysiloxane and (B) an organic solvent.

Examples of the polysiloxane (A) include a product of hydrolysis and condensation obtained by hydrolyzing and condensing at least one silane compound selected from the group consisting of compounds represented by the following formula (1) (hereinafter referred to as "compounds (1)"), compounds represented by the following formula (2) (hereinafter referred to as "compounds (2)"), and compounds represented by the following formula (3) (hereinafter referred to as "compounds (3)");

RₐSi(OR¹)₄₋ₐ (1)

wherein R represents a hydrogen atom, a fluorine atom or a monovalent organic group; R¹ represents a monovalent organic group; and a is an integer of 1 or 2;

Si(OR²)₄ (2)

wherein R² represents a monovalent organic group;

R³_{b}(R⁴O)_{3-b}Si-(R⁷)_{d}-Si(OR⁵)_{3-c}R⁶_{c} (3)

wherein R³ to R⁶ may be the same or different and each represent a monovalent organic group; b and c may be the same or different and each are a number of 0 to 2; R⁷ represents an oxygen atom, a phenylene group or a group represented by -(CH₂)ₙ-, wherein n is an integer of 1 to 6; and d is 0 or 1.

### Compounds (1):

Examples of the monovalent organic groups represented by R and R¹ in formula (1) include alkyl, aryl, allyl and glycidyl groups. In formula (1), R is preferably a monovalent organic group, more preferably an alkyl or phenyl group.

The alkyl group preferably has 1 to 5 carbon atoms, and examples thereof include methyl, ethyl, propyl and butyl. These alkyl groups may be linear or branched, and may be ones in which one or more of the hydrogen atoms have been replaced, for example, with fluorine atoms.

In formula (1), examples of the aryl group include phenyl, naphthyl, methylphenyl, ethylphenyl, chlorophenyl, bromophenyl and fluorophenyl.

Specific examples of the compounds (1) include:
trimethoxysilane, triethoxysilane, tri-n-propoxysilane, triisopropoxysilane, tri-n-butoxysilane, tri-sec-butoxysilane, tri-tert-butoxysilane, triphenoxysilane, fluorotrimethoxysilane, fluorotriethoxysilane, fluorotri-n-propoxysilane, fluorotriisopropoxysilane, fluorotri-n-butoxysilane, fluorotri-sec-butoxysilane, fluorotri-tert- butoxysilane and fluorotriphenoxysilane;
methyltrimethoxysilane, methyltriethoxysilane, methyltri-n-propoxysilane, methyltri-iso-propoxysilane, methyltri-n-butoxysilane, methyltri-sec-butoxysilane, methyltri-tert-butoxysilane, methyltriphenoxysilane, ethyltrimethoxysilane, ethyltriethoxysilane, ethyltri-n-propoxysilane, ethyltri-iso-propoxysilane, ethyltri-n-butoxysilane, ethyltri-sec-butoxysilane, ethyltri-tert-butoxysilane, ethyltriphenoxysilane, vinyltrimethoxysilane, vinyltriethoxysilane, vinyltri-n-propoxysilane, vinyltri-iso-propoxysilane, vinyltri-n-butoxysilane, vinyltri-sec-butoxysilane, vinyltri-tert-butoxysilane, vinyltriphenoxysilane, n-propyltrimethoxysilane, n-propyltriethoxysilane, n-propyltri-n-propoxysilane, n-propyltriisopropoxysilane, n-propyltri-n-butoxysilane, n-propyltri-sec-butoxysilane, n-propyltri-tert-butoxysilane, n-propyltriphenoxysilane, isopropyltrimethoxysilane, isopropyltriethoxysilane, isopropyltri-n-propoxysilane, isopropyltriisopropoxysilane, isopropyltri-n-butoxysilane, isopropyltri-sec-butoxysilane, isopropyltri-tert-butoxysilane, isopropyltriphenoxysilane, n-butyltrimethoxysilane, n-butyltriethoxysilane, n-butyltri-n-propoxysilane, n-butyltriisopropoxysilane, n-butyltri-n-butoxysilane, n-butyltri-sec-butoxysilane, n-butyltri-tert-butoxysilane, n-butyltriphenoxysilane, sec-butyltrimethoxysilane, sec-butyltriethoxysilane, sec-butyltri-n-propoxysilane, sec-butyltriisopropoxysilane, sec-butyltri-n-butoxysilane, sec-butyltri-sec-butoxysilane, sec-butyltri-tert-butoxysilane, sec-butyltriphenoxysilane, tert-butyltrimethoxysilane, tert-butyltriethoxysilane, tert-butyltri-n-propoxysilane, tert-butyltriisopropoxysilane, tert-butyltri-n-butoxysilane, tert-butyltri-sec-butoxysilane, tert-butyltri-tert-butoxysilane, tert-butyltriphenoxysilane, phenyltrimethoxysilane, phenyltriethoxysilane, phenyltri-n-propoxysilane, phenyltriisopropoxysilane, phenyltri-n-butoxysilane, phenyltri-sec-butoxysilane, phenyltri-tert-butoxysilane, phenyltriphenoxysilane, vinyltrimethoxysilane, vinyltriethoxysilane, γ-aminopropyltrimethoxysilane, γ-aminopropyltriethoxysilane, γ-glycidoxypropyltrimethoxysilane, γ-glycidoxypropyltriethoxysilane, γ-trifluoropropyltrimethoxysilane, and γ-trifluoropropyltriethoxysilane; and
dimethyldimethoxysilane, dimethyldiethoxysilane, dimethyldi-n-propoxysilane, dimethyldiisopropoxysilane, dimethyldi-n-butoxysilane, dimethyldi-sec-butoxysilane, dimethyldi-tert-butoxysilane, dimethyldiphenoxysilane, diethyldimethoxysilane, diethyldiethoxysilane, diethyldi-n-propoxysilane, diethyldiisopropoxysilane, diethyldi-n-butoxysilane, diethyldi-sec-butoxysilane, diethyldi-tert-butoxysilane, diethyldiphenoxysilane, di-n-propyldimethoxysilane, di-n-propyldiethoxysilane, di-n-propyldi-n-propoxysilane, di-n-propyldiisopropoxysilane, di-n-propyldi-n-butoxysilane, di-n-propyldi-sec-butoxysilane, di-n-propyldi-tert-butoxysilane, di-n-propyldiphenoxysilane, diisopropyldimethoxysilane, diisopropyldiethoxysilane, diisopropyldi-n-propoxysilane, diisopropyldiisopropoxysilane, diisopropyldi-n-butoxysilane, diisopropyldi-sec-butoxysilane, diisopropyldi-tert-butoxysilane, diisopropyldiphenoxysilane, di-n-butyldimethoxysilane, di-n-butyldiethoxysilane, di-n-butyldi-n-propoxysilane, di-n-butyldiisopropoxysilane, di-n-butyldi-n-butoxysilane, di-n-butyldi-sec-butoxysilane, di-n-butyldi-tert-butoxysilane, di-n-butyldiphenoxysilane, di-sec-butyldimethoxysilane, di-sec-butyldiethoxysilane, di-sec-butyldi-n-propoxysilane, di-sec-butyldiisopropoxysilane, di-sec-butyldi-n-butoxysilane, di-sec-butyldi-sec-butoxysilane, di-sec-butyldi-tert-butoxysilane, di-sec-butyldiphenoxysilane, di-tert-butyldimethoxysilane, di-tert-butyldiethoxysilane, di-tert-butyldi-n-propoxysilane, di-tert-butyldiisopropoxysilane, di-tert-butyldi-n-butoxysilane, di-tert-butyldi-sec-butoxysilane, di-tert-butyldi-tert-butoxysilane, di-tert-butyldiphenoxysilane, diphenyldimethoxysilane, diphenyldiethoxysilane, diphenyldi-n-propoxysilane, diphenyldiisopropoxysilane, diphenyldi-n-butoxysilane, diphenyldi-sec-butoxysilane, diphenyldi-tert-butoxysilane, diphenyldiphenoxysilane, and divinyltrimethoxysilane.

Preferred examples of the compounds (1) include methyltrimethoxysilane, methyltriethoxysilane, methyltri-n-propoxysilane, methyltriisopropoxysilane, ethyltrimethoxysilane, ethyltriethoxysilane, vinyltrimethoxysilane, vinyltriethoxysilane, phenyltrimethoxysilane, phenyltriethoxysilane, dimethyldimethoxysilane, dimethyldiethoxysilane, diethyldimethoxysilane, diethyldiethoxysilane, diphenyldimethoxysilane, and diphenyldiethoxysilane.

Those compounds may be used alone or in combination of two or more thereof.

### Compounds (2):

Examples of the monovalent organic group represented by R² in formula (2) include the same monovalent organic groups as those enumerated above with regard to formula (1).

Examples of the compounds (2) include tetramethoxysilane, tetraethoxysilane, tetra-n-propoxysilane, tetraisopropoxysilane, tetra-n-butoxysilane, tetra-sec-butoxysilane, tetra-tert-butoxysilane and tetraphenoxysilane.

### Compounds (3):

Examples of the monovalent organic groups represented by R³ to R⁶ in formula (3) include the same monovalent organic groups as those enumerated above with regard to formula (1).

Examples of the compounds (3) wherein R⁷ in formula (3) is an oxygen atom include
hexamethoxydisiloxane, hexaethoxydisiloxane, hexaphenoxydisiloxane, 1,1,1,3,3-pentamethoxy-3-methyldisiloxane, 1,1,1,3,3-pentaethoxy-3-methyldisiloxane, 1,1,1,3,3-pentaphenoxy-3-methyldisiloxane, 1,1,1,3,3-pentamethoxy-3-ethyldisiloxane, 1,1,1,3,3-pentaethoxy-3-ethyldisiloxane, 1,1,1,3,3-pentaphenoxy-3-ethyldisiloxane, 1,1,1,3,3-pentamethoxy-3-phenyldisiloxane, 1,1,1,3,3-pentaethoxy-3-phenyldisiloxane, 1,1,1,3,3-pentaphenoxy-3-phenyldisiloxane, 1,1,3,3-tetramethoxy-1,3-dimethyldisiloxane, 1,1,3,3-tetraethoxy-1,3-dimethyldisiloxane, 1,1,3,3-tetraphenoxy-1,3-dimethyldisiloxane, 1,1,3,3-tetramethoxy-1,3-diethyldisiloxane, 1,1,3,3-tetraethoxy-1,3-diethyldisiloxane, 1,1,3,3-tetraphenoxy-1,3-diethyldisiloxane, 1,1,3,3-tetramethoxy-1,3-diphenyldisiloxane, 1,1,3,3-tetraethoxy-1,3-diphenyldisiloxane, 1,1,3,3-tetraphenoxy-1,3-diphenyldisiloxane, 1,1,3-trimethoxy-1,3,3-trimethyldisiloxane, 1,1,3-triethoxy-1,3,3-trimethyldisiloxane, 1,1,3-triphenoxy-1,3,3-trimethyldisiloxane, 1,1,3-trimethoxy-1,3,3-triethyldisiloxane, 1,1,3-triethoxy-1,3,3-triethyldisiloxane, 1,1,3-triphenoxy-1,3,3-triethyldisiloxane, 1,1,3-trimethoxy-1,3,3-triphenyldisiloxane, 1,1,3-triethoxy-1,3,3-triphenyldisiloxane, 1,1,3-triphenoxy-1,3,3-triphenyldisiloxane, 1,3-dimethoxy-1,1,3,3-tetramethyldisiloxane, 1,3-diethoxy-1,1,3,3-tetramethyldisiloxane, 1,3-diphenoxy-1,1,3,3-tetramethyldisiloxane, 1,3-dimethoxy-1,1,3,3-tetraethyldisiloxane, 1,3-diethoxy-1,1,3,3-tetraethyldisiloxane, 1,3-diphenoxy-1,1,3,3-tetraethyldisiloxane, 1,3-dimethoxy-1,1,3,3-tetraphenyldisiloxane, 1,3-diethoxy-1,1,3,3-tetraphenyldisiloxane, and 1,3-diphenoxy-1,1,3,3-tetraphenyldisiloxane.

Preferred of those compounds are hexamethoxydisiloxane, hexaethoxydisiloxane, 1,1,3,3-tetramethoxy-1,3-dimethyldisiloxane, 1,1,3,3-tetraethoxy-1,3-dimethyldisiloxane, 1,1,3,3-tetramethoxy-1,3-diphenyldisiloxane, 1,3-dimethoxy-1,1,3,3-tetramethyldisiloxane, 1,3-diethoxy-1,1,3,3-tetramethyldisiloxane, 1,3-dimethoxy-1,1,3,3-tetraphenyldisiloxane, and 1,3-diethoxy-1,1,3,3-tetraphenyldisiloxane.

Examples of the compounds represented by formula (3) wherein d is 0 include hexamethoxydisilane, hexaethoxydisilane, hexaphenoxydisilane, 1,1,1,2,2-pentamethoxy-2-methyldisilane, 1,1,1,2,2-pentaethoxy-2-methyldisilane, 1,1,1,2,2-pentaphenoxy-2-methyldisilane, 1,1,1,2,2-pentamethoxy-2-ethyldlsilane, 1,1,1,2,2-pentaethoxy-2-ethyldisilane, 1,1,1,2,2-pentaphenoxy-2-ethyldisilane, 1,1,1,2,2-pentamethoxy-2-phenyldisilane, 1,1,1,2,2-pentaethoxy-2-phenyldisilane, 1,1,1,2,2-pentaphenoxy-2-phenyldisilane, 1,1,2,2-tetramethoxy-1,2-dimethyldisilane, 1,1,2,2-tetraethoxy-1,2-dimethyldisilane, 1,1,2,2-tetraphenoxy-1,2-dimethyldisilane, 1,1,2,2-tetramethoxy-1,2-diethyldisilane, 1,1,2,2-tetraethoxy-1,2-diethyldisilane, 1,1,2,2-tetraphenoxy-1,2-diethyldisilane, 1,1,2,2-tetramethoxy-1,2-diphenyldisilane, 1,1,2,2-tetraethoxy-1,2-diphenyldisilane, 1,1,2,2-tetraphenoxy-1,2-diphenyldisilane, 1,1,2-trimethoxy-1,2,2-trimethyldisilane, 1,1,2-triethoxy-1,2,2-trimethyldisilane, 1,1,2-triphenoxy-1,2,2-trimethyldisilane, 1,1,2-trimethoxy-1,2,2-triethyldisilane, 1,1,2-triethoxy-1,2,2-triethyldisilane, 1,1,2-triphenoxy-1,2,2-triethyldisilane, 1,1,2-trimethoxy-1,2,2-triphenyldisilane, 1,1,2-triethoxy-1,2,2-triphenyldisilane, 1,1,2-triphenoxy-1,2,2-triphenyldisilane, 1,2-dimethoxy-1,1,2,2-tetramethyldisilane, 1,2-diethoxy-1,1,2,2-tetramethyldisilane, 1,2-diphenoxy-1,1,2,2-tetramethyldisilane, 1,2-dimethoxy-1,1,2,2-tetraethyldisilane, 1,2-diethoxy-1,1,2,2-tetraethyldisilane, 1,2-diphenoxy-1,1,2,2-tetraethyldisilane, 1,2-dimethoxy-1,1,2,2-tetraphenyldisilane, 1,2-diethoxy-1,1,2,2-tetraphenyldisilane, and 1,2-diphenoxy-1,1,2,2-tetraphenyldisilane.

Preferred of those compounds are
hexamethoxydisilane, hexaethoxydisilane, 1,1,2,2-tetramethoxy-1,2-dimethyldisilane, 1,1,2,2-tetraethoxy-1,2-dimethyldisilane, 1,1,2,2-tetramethoxy-1,2-diphenyldisilane, 1,2-dimethoxy-1,1,2,2-tetramethyldisilane, 1,2-diethoxy-1,1,2,2-tetramethyldisilane, 1,2-dimethoxy-1,1,2,2-tetraphenyldisilane, and 1,2-diethoxy-1,1,2,2-tetraphenyldisilane.

Examples of the compounds represented by formula (3) wherein R⁷ is a group represented by -(CH₂)ₙ- include bis(trimethoxysilyl)methane, bis(triethoxysilyl)methane, bis(tri-n-propoxysilyl)methane, bis(triisopropoxysilyl)methane, bis(tri-n-butoxysilyl)methane, bis(tri-sec-butoxysilyl)methane, bis(tri-t-butoxysilyl)methane, 1,2-bis(trimethoxysilyl)ethane, 1,2-bis(triethoxysilyl)ethane, 1,2-bis(tri-n-propoxysilyl)ethane, 1,2-bis(triisopropoxysilyl)ethane, 1,2-bis(tri-n-butoxysilyl)ethane, 1,2-bis(tri-sec-butoxysilyl)ethane, 1,2-bis(tri-t-butoxysilyl)ethane, 1-(dimethoxymethylsilyl)-1-(trimethoxysilyl) methane, 1-(diethoxymethylsilyl)-1-(triethoxysilyl)methane, 1-(di-n-propoxymethylsilyl)-1-(tri-n-propoxysilyl)methane, 1-(diisopropoxymethylsilyl)-1-(triisopropoxysilyl)methane, 1-(di-n-butoxymethylsilyl)-1-(tri-n-butoxysilyl)methane, 1-(di-sec-butoxymethylsilyl)-1-(tri-sec-butoxysilyl)methane, 1-(di-t-butoxymethylsilyl)-1-(tri-t-butoxysilyl)methane, 1-(dimethoxymethylsilyl)-2-(trimethoxysilyl)ethane, 1-(diethoxymethylsilyl)-2-(triethoxysilyl)ethane, 1-(di-n-propoxymethylsilyl)-2-(tri-n-propoxysilyl)ethane, 1-(diisopropoxymethylsilyl)-2-(triisopropoxysilyl)ethane, 1- (di-n-butoxymethylsilyl) -2- (tri-n-butoxysilyl) ethane, 1-(di-sec-butoxymethylsilyl)-2-(tri-sec-butoxysilyl)ethane, 1-(di-t-butoxymethylsilyl)-2-(tri-t-butoxysilyl)ethane, bis(dimethoxymethylsilyl)methane, bis(diethoxymethylsilyl)methane, bis(di-n-propoxymethylsilyl)methane, bis(diisopropoxymethylsilyl)methane, bis(di-n-butoxymethylsilyl)methane, bis(di-sec-butoxymethylsilyl)methane, bis(di-t-butoxymethylsilyl)methane, 1,2-bis(dimethoxymethylsilyl)ethane, 1,2-bis(diethoxymethylsilyl)ethane, 1,2-bis(di-n-propoxymethylsilyl)ethane, 1,2-bis(diisopropoxymethylsilyl)ethane, 1,2-bis(di-n-butoxymethylsilyl)ethane, 1,2-bis(di-sec-butoxymethylsilyl)ethane, 1,2-bis(di-t-butoxymethylsilyl)ethane, 1,2-bis(trimethoxysilyl)benzene, 1,2-bis(triethoxysilyl)benzene, 1,2-bis(tri-n-propoxysilyl)benzene, 1,2-bis(triisopropoxysilyl)benzene, 1,2-bis(tri-n-butoxysilyl)benzene, 1,2-bis(tri-sec-butoxysilyl)benzene, 1,2-bis(tri-t-butoxysilyl)benzene, 1,3-bis(trimethoxysilyl)benzene, 1,3-bis(triethoxysilyl)benzene, 1,3-bis(tri-n-propoxysilyl)benzene, 1,3-bis(triisopropoxysilyl)benzene, 1,3-bis(tri-n-butoxysilyl)benzene,1,3-bis(tri-sec-butoxysilyl)benzene, 1,3-bis(tri-t-butoxysilyl)benzene, 1,4-bis (trimethoxysilyl)benzene, 1,4-bis(triethoxysilyl)benzene, 1,4-bis(tri-n-propoxysilyl)benzene, 1,4-bis(triisopropoxysilyl)benzene, 1,4-bis(tri-n-butoxysilyl)benzene, 1,4-bis(tri-sec-butoxysilyl)benzene, and 1,4-bis (tri-t-butoxysilyl)benzene.

Preferred of those compounds are bis(trimethoxysilyl)methane, bis(triethoxysilyl)methane, 1,2-bis(trimethoxysilyl)ethane, 1,2-bis(triethoxysilyl)ethane, 1-(dimethoxymethylsilyl)-1-(trimethoxysilyl) methane, 1-(diethoxymethylsilyl)-1-(triethoxysilyl)methane, 1-(dimethoxymethylsilyl)-2-(trimethoxysilyl)ethane, 1-(diethoxymethylsilyl)-2-(triethoxysilyl)ethane, bis(dimethoxymethylsilyl)methane, bis(diethoxymethylsilyl)methane, 1,2-bis(dimethoxymethylsilyl)ethane, 1,2-bis(diethoxymethylsilyl)ethane, 1,2-bis(trimethoxysilyl)benzene, 1,2-bis(triethoxysilyl)benzene, 1,3-bis(trimethoxysilyl)benzene, 1,3-bis(triethoxysilyl)benzene, 1,4-bis(trimethoxysilyl)benzene, and 1,4-bis(triethoxysilyl)benzene.

In the invention, the compounds (1), (2), and (3) described above may be used alone or in combination of two or more thereof to constitute ingredient (A).

A catalyst may be used in hydrolyzing and condensing one or more of the compounds (1) to (3) to synthesize ingredient (A). Examples of this catalyst include metal chelate compounds, organic acids, inorganic acids, organic bases, and inorganic bases.

Examples of the metal chelate compounds include titanium chelate compounds such as triethoxymono (acetylacetonato) titanium, tri-n-propoxymono(acetylacetonato)titanium, triisopropoxymono(acetylacetonato)titanium, tri-n-butoxymono(acetylacetonato)titanium, tri-sec-butoxymono(acetylacetonato)titanium, tri-tert-butoxymono(acetylacetonato)titanium, diethoxybis(acetylacetonato)titanium, di-n-propoxybis(acetylacetonato)titanium, diisopropoxybis(acetylacetonato)titanium, di-n-butoxybis(acetylacetonato)titanium, di-sec-butoxybis(acetylacetonato)titanium, di-tert-butoxybis (acetylacetonato) titanium, monoethoxytris(acetylacetonato)titanium, mono-n-propoxytris (acetylacetonato) titanium, monoisopropoxytris(acetylacetonato) titanium, mono-n-butoxytris (acetylacetonato)titanium, mono-sec-butoxytris(acetylacetonato)titanium, mono-tert-butoxytris(acetylacetonato)titanium, tetrakis(acetylacetonato)titanium, triethoxymono(ethylacetoacetato)titanium, tri-n-propoxymono(ethylacetoacetato)titanium, triisopropoxymono(ethylacetoacetato)titanium, tri-n-butoxymono(ethylacetoacetato)titanium, tri-sec-butoxymono (ethylacetoacetato) titanium, tri-tert-butoxymono(ethylacetoacetato)titanium, diethoxybis(ethylacetoacetato)titanium, di-n-propoxybis(ethylacetoacetato)titanium, diisopropoxybis(ethylacetoacetato)titanium, di-n-butoxybis(ethylacetoacetato)titanium, di-sec-butoxybis(ethylacetoacetato)titanium, di-tert-butoxybis(ethylacetoacetato)titanium, monoethoxytris(ethylacetoacetato)titanium, mono-n-propoxytris(ethylacetoacetato)titanium, monoisopropoxytris(ethylacetoacetato)titanium, mono-n-butoxytris (ethylacetoacetato) titanium, mono-sec-butoxytris(ethylacetoacetato)titanium, mono-tert-butoxytris(ethylacetoacetato)titanium, tetrakis(ethylacetoacetato)titanium, mono(acetylacetonato)tris(ethylacetoacetato)titanium, bis(acetylacetonato)bis(ethylacetoacetato)titanium, and tris(acetylacetonato)mono(ethylacetoacetato)titanium; zirconium chelate compounds such as triethoxymono(acetylacetonato)zirconium, tri-n-propoxymono(acetylacetonato)zirconium, triisopropoxymono(acetylacetonato)zirconium, tri-n-butoxymono(acetylacetonato)zirconium, tri-sec-butoxymono(acetylacetonato)zirconium, tri-tert-butoxymono(acetylacetonato)zirconium, diethoxybis(acetylacetonato)zirconium, di-n-propoxybis(acetylacetonato)zirconium, diisopropoxybis(acetylacetonato)zirconium, di-n-butoxybis(acetylacetonato)zirconium, di-sec-butoxybis(acetylacetonato)zirconium, di-tert-butoxybis(acetylacetonato)zirconium, monoethoxytris(acetylacetonato)zirconium, mono-n-propoxytris(acetylacetonato)zirconium, monoisopropoxytris(acetylacetonato)zirconium, mono-n-butoxytris(acetylacetonato)zirconium, mono-sec-butoxytris(acetylacetonato)zirconium, mono-tert-butoxytris(acetylacetonato)zirconium, tetrakis(acetylacetonato)zirconium, triethoxymono(ethylacetoacetato)zirconium, tri-n-propoxymono(ethylacetoacetato)zirconium, triisopropoxymono(ethylacetoacetato)zirconium, tri-n-butoxymono(ethylacetoacetato)zirconium, tri-sec-butoxymono(ethylacetoacetato)zirconium, tri-tert-butoxymono(ethylacetoacetato)zirconium, diethoxybis(ethylacetoacetato)zirconium, di-n-propoxybis(ethylacetoacetato)zirconium, diisopropoxybis(ethylacetoacetato)zirconium, di-n-butoxybis(ethylacetoacetato)zirconium, di-sec-butoxybis(ethylacetoacetato)zirconium, di-tert-butoxybis(ethylacetoacetato)zirconium, monoethoxytris(ethylacetoacetato)zirconium, mono-n-propoxytris(ethylacetoacetato)zirconium, monoisopropoxytris(ethylacetoacetato)zirconium, mono-n-butoxytris(ethylacetoacetato)zirconium, mono-sec-butoxytris(ethylacetoacetato)zirconium, mono-tert-butoxytris(ethylacetoacetato)zirconium, tetrakis(ethylacetoacetato)zirconium, mono(acetylacetonato)tris(ethylacetoacetato)zirconium, bis(acetylacetonato)bis(ethylacetoacetato)zirconium and tris(acetylacetonato)mono(ethylacetoacetato)zirconium; and aluminum chelate compounds such as tris(acetylacetonato)aluminum and tris(ethylacetoacetato)aluminum.

Examples of the organic acids include acetic acid, propionic acid, butanoic acid, pentanoic acid, hexanoic acid, heptanoic acid, octanoic acid, nonanoic acid, decanoic acid, oxalic acid, maleic acid, methylmalonic acid, adipic acid, sebacic acid, gallic acid, butyric acid, mellitic acid, arachidonic acid, shikimic acid, 2-ethylhexanoic acid, oleic acid, stearic acid, linoleic acid, linolenic acid, salicylic acid, benzoic acid, p-aminobenzoic acid, p-toluenesulfonic acid, benzenesulfonic acid, monochloroacetic acid, dichloroacetic acid, trichloroacetic acid, trifluoroacetic acid, formic acid, malonic acid, sulfonic acids, phthalic acid, fumaric acid, citric acid and tartaric acid.

Examples of the inorganic acids include hydrochloric acid, nitric acid, sulfuric acid, hydrofluoric acid and phosphoric acid.

Examples of the organic bases include pyridine, pyrrole, piperazine, pyrrolidine, piperidine, picoline, trimethylamine, triethylamine, monoethanolamine, diethanolamine, dimethylmonoethanolamine, monomethyldiethanolamine, triethanolamine, diazabicyclooctane, diazabicyclononane, diazabicycloundecene, tetramethylammonium hydroxide, urea and creatinine.

Examples of the inorganic bases include ammonia, sodium hydroxide, potassium hydroxide, barium hydroxide and calcium hydroxide.

Preferred of those catalysts are metal chelate compounds, organic acids and inorganic acids. More preferred are organic acids. Especially preferred organic acids are acetic acid, oxalic acid, maleic acid and malonic acid. Use of an organic acid as a catalyst is preferred in that polymer precipitation and gelation are less apt to occur during the hydrolysis and condensation reactions.

Those catalysts may be used alone or in combination of two or more thereof.

The amount of the catalyst to be used is generally from 0.00001 to 0.05 mol, preferably from 0.00001 to 0.01 mol, per mole of all R¹O, R²O, R⁴O, and R⁵O groups contained in the compounds (1) to (3).

In the case where ingredient (A) is a condensate of one or more of the compounds (1) to (3), the molecular weight thereof is generally from about 500 to 300,000, preferably from about 700 to 200,000, more preferably from about 1,000 to 100,000, in terms of a weight average molecular weight calculated for standard polystyrene.

In ingredient (A), the proportion of the product of hydrolysis and condensation derived from each compound is as follows, in terms of the product of complete hydrolysis and condensation. The content of the product of hydrolysis and condensation derived from the compound (3) is generally from 5 to 60% by weight, preferably from 5 to 50% by weight, more preferably from 5 to 40% by weight, based on the sum of all the products of hydrolysis and condensation derived from the compounds (1), (2) and (3). Furthermore, [weight of the product derived from the compound (1)] <[weight of the product derived from the compound (2)]. In case where the content of the product of hydrolysis and condensation derived from the compound (3) is lower than 5% by weight based on the sum of the products of hydrolysis and condensation derived from the compounds (1) to (3) in terms of the products of complete hydrolysis and condensation, the coating fluid gives a film having reduced mechanical strength. On the other hand, in case where the content thereof exceeds 60% by weight, the coating fluid gives a film which has too high water-absorbing properties and reduced electrical properties. Furthermore, in case where the amount by weight of the product of hydrolysis and condensation derived from the compound (1) is not smaller than that of the product of hydrolysis and condensation derived from the compound (2), the coating fluid gives a film having poor strength.

The term "product of complete hydrolysis and condensation" as used herein means a product in which all the SiOR¹, SiOR², SiOR⁴ and SiOR⁵ groups contained in the compounds (1) to (3) have been hydrolyzed into SiOH groups and then completely condensed to form siloxane structures.

The inorganic dielectric film in the invention is preferably formed by dissolving the product of hydrolysis and condensation of one or more of those silane compounds in an organic solvent (B), applying the resulting coating fluid, and then heating the coating layer.

The organic solvent (B) may comprise at least one member selected from the group consisting of alcohol solvents, ketone solvents, amide solvents, ester solvents and aprotic solvents.

Examples of the alcohol solvents include monohydric alcohols such as methanol, ethanol, n-propanol, isopropanol, n-butanol, isobutanol, sec-butanol, t-butanol, n-pentanol, isopentanol, 2-methylbutanol, sec-pentanol, t-pentanol, 3-methoxybutanol, n-hexanol, 2-methylpentanol, sec-hexanol, 2-ethylbutanol, sec-heptanol, heptanol-3, n-octanol, 2-ethylhexanol, sec-octanol, n-nonyl alcohol, 2,6-dimethylheptanol-4, n-decanol, sec-undecylalcohol, trimethylnonyl alcohol, sec-tetradecyl alcohol, sec-heptadecyl alcohol, phenol, cyclohexanol, methylcyclohexanol, 3,3,5-trimethylcyclohexanol, benzyl alcohol and diacetone alcohol; polyhydric alcohols such as ethylene glycol, 1,2-propylene glycol, 1,3-butylene glycol, pentanediol-2,4, 2-methylpentanediol-2,4, hexanediol-2,5, heptanediol-2,4, 2-ethylhexanediol-1,3, diethylene glycol, dipropylene glycol, triethylene glycol and tripropylene glycol; and partial ethers of polyhydric alcohols, such as ethylene glycol monomethyl ether, ethylene glycol monoethyl ether, ethylene glycol monopropyl ether, ethylene glycol monobutyl ether, ethylene glycol monohexyl ether, ethylene glycol monophenyl ether, ethylene glycol mono-2-ethylbutyl ether, diethylene glycol monomethyl ether, diethylene glycol monoethyl ether, diethylene glycol monopropyl ether, diethylene glycol monobutyl ether, diethylene glycol monohexyl ether, propylene glycol monomethyl ether, propylene glycol monoethyl ether, propylene glycol monopropyl ether, propylene glycol monobutyl ether, dipropylene glycol monomethyl ether, dipropylene glycol monoethyl ether and dipropylene glycol monopropyl ether.

Those alcohol solvents may be used alone or in combination of two or more thereof.

Preferred of those alcohols are n-propanol, isopropanol, n-butanol, isobutanol, sec-butanol, t-butanol, n-pentanol, isopentanol, 2-methylbutanol, sec-pentanol, t-pentanol, 3-methoxybutanol, n-hexanol, 2-methylpentanol, sec-hexanol, 2-ethylbutanol, propylene glycol monomethyl ether, propylene glycol monoethyl ether, propylene glycol monopropyl ether and propylene glycol monobutyl ether.

Examples of the ketone solvents include acetone, methyl ethyl ketone, methyl n-propyl ketone, methyl n-butyl ketone, diethyl ketone, methyl isobutyl ketone, methyl n-pentyl ketone, ethyl n-butyl ketone, methyl n-hexyl ketone, diisobutyl ketone, trimethylnonanone, cyclohexanone, 2-hexanone, methylcyclohexanone, 2,4-pentanedione, acetonylacetone, acetophenone and fenchone. Examples thereof further include β-diketones such as acetylacetone, 2,4-hexanedione, 2,4-heptanedione, 3,5-heptanedione, 2,4-octanedione, 3,5-octanedione, 2,4-nonanedione, 3,5-nonanedione, 5-methyl-2,4-hexanedione, 2,2,6,6-tetramethyl-3,5-heptanedione and 1,1,1,5,5,5-hexafluoro-2,4-heptanedione.

Those ketone solvents may be used alone or in combination of two or more thereof.

Examples of the amide solvents include formamide, N-methylformamide, N,N-dimethylformamide, N-ethylformamide, N,N-diethylformamide, acetamide, N-methylacetamide, N,N-dimethylacetamide, N-ethylacetamide, N,N-diethylacetamide, N-methylpropionamide, N-methylpyrrolidone, N-formylmorpholine, N-formylpiperidine, N-formylpyrrolidine, N-acetylmorpholine, N-acetylpiperidine and N-acetylpyrrolidine.

Those amide solvents may be used alone or in combination of two or more thereof.

Examples of the ester solvents include diethyl carbonate, ethylene carbonate, propylene carbonate, methyl acetate, ethyl acetate, γ-butyrolactone, γ-valerolactone, n-propyl acetate, isopropyl acetate, n-butyl acetate, isobutyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxytriglycol acetate, ethyl propionate, n-butyl propionate, isoamyl propionate, diethyl oxalate, di-n-butyl oxalate, methyl lactate, ethyl lactate, n-butyl lactate, n-amyl lactate, diethyl malonate, dimethyl phthalate and diethyl phthalate.

Those ester solvents may be used alone or in combination of two or more thereof.

Examples of the aprotic solvents include acetonitrile, dimethyl sulfoxide, N,N,N',N'-tetraethylsulfamide, hexamethylphosphoric triamide, N-methylmorpholone, N-methylpyrrole, N-ethylpyrrole, N-methylpiperidine, N-ethylpiperidine, N,N-dimethylpiperazine, N-methylimidazole, N-methyl-4-piperidone, N-methyl-2-piperidone, N-methyl-2-pyrrolidone, 1,3-dimethyl-2-imidazolidinone, and 1,3-dimethyltetrahydro-2(1H)-pyrimidinone.

The organic solvents (B) enumerated above can be used alone or as a mixture of two or more thereof.

Preferred of those organic solvents are alcohol solvents.

Examples of coating techniques that can be used for applying the coating fluid include spin coating, dipping, and roller blade coating.

This coating operation can be conducted so as to form a coating film having a thickness on a dry basis of from about 0.05 to 1.5 µm in the case of single coating or from about 0.1 to 3 µm in the case of double coating.

In general, the thickness of the coating film to be formed is from 0.2 to 20 µm.

In this operation, heating can be conducted with a hot plate, oven, furnace or the like, for example, in the air, in a nitrogen or argon atmosphere, under vacuum or under reduced pressure having a controlled oxygen concentration.

In order to control the curing rate of the ingredient (A), stepwise heating or a suitably selected atmosphere, such as a nitrogen, air, oxygen or reduced pressure atmosphere, can be used according to need.

The silica- or siloxane-based film thus obtained has a dielectric constant of generally from 1.5 to 3.2 and a density of generally from 0.35 to 1.2 g/cm³, preferably from 0.4 to 1.1 g/cm³, more preferably from 0.5 to 1.0 g/cm³. In case where the density of the film is lower than 0.35 g/cm³, the coating film has impaired mechanical strength. On the other hand, in case where the density thereof exceeds 1.2 g/cm³, a low dielectric constant cannot be obtained.

The inorganic dielectric film in the invention can be one formed from one or more of the aforementioned silane compounds by CVD.

### Organic Dielectric film

The organic dielectric film preferably comprises a heat-resistant organic resin having a glass transition point of 400°C or higher and a heat decomposition temperature of 500°C or higher.

In the invention, the organic dielectric film is not removed during the wiring steps and remains in the multilayer structure. Because of this, use of an organic dielectric film having a glass transition point lower than 400°C is undesirable in that it may deform during multilayer wiring to pose problems such as wiring connection failures and delamination.

The organic dielectric film has a dielectric constant of preferably 4.0 or lower, more preferably 3.5 or lower.

The thickness of the organic dielectric film is determined by the thickness of the inorganic dielectric film and etching selective ratio between the organic dielectric film and the inorganic dielectric film during etching. However, the thickness thereof is generally from 10 to 2,000 nm.

The material of the organic dielectric film is preferably an organic polymer selected from polyarylenes, poly(arylene ether)s, polybenzoxazole, and polyimides.

This organic dielectric film can be formed by dissolving the organic polymer in an organic solvent, applying the solution, and then heating the coating layer.

In forming a film from the coating fluid containing the organic polymer, burning is conducted at a temperature of preferably from 50 to 600°C, more preferably from 200 to 500°C.

The metal oxide film in the invention is a metal oxide film containing at least one metal selected from the group consisting of aluminum, gallium, indium, thallium, silicon, germanium, tin, lead, titanium, zirconium, hafnium, vanadium, niobium, tantalum, chromium, molybdenum, tungsten, manganese, zinc, cadmium, arsenic, antimony, bismuth and cerium as a constituent element.

The metal oxide film in the invention is preferably formed by applying a coating fluid prepared by dissolving a product of the (partial) hydrolysis and condensation of an alkoxide of the at least one metallic element in an organic solvent and then heating the coating layer. The metal alkoxide used as a starting material is preferably an alkoxysilane. Examples of the alkoxysilane include the same silane compounds as those usable for forming the inorganic dielectric film. The organic solvent may comprise at least one member selected from the group consisting of alcohol solvents, ketone solvents, amide solvents, ester solvents and aprotic solvents.

Preferred of those organic solvents are alcohol solvents.

Although the metal oxide film in the invention is usually obtained by applying and burning a product of the (partial) hydrolysis and condensation of a metal alkoxide, a technique for curing and insolubilizing the coating film may be used which comprises incorporating a latent acid generator into the coating fluid to accelerate the curing reaction in a film-forming step. Examples of the latent acid generator used for this purpose include latent hot acid generators and latent photo-acid generators.

The latent hot acid generators are compounds which generate an acid upon heating to generally 50 to 450°C, preferably 200 to 350°C. Specific examples thereof include onium salts such as sulfonium salts, benzothiazolium salts, ammonium salts, and phosphonium salts. The latent photo-acid generators are compounds which generate an acid upon ultraviolet irradiation at generally from 1 to 100 mJ, preferably from 10 to 50 mJ.

After the coating fluid containing a product of the (partial) hydrolysis and condensation of a metal alkoxide as the main component is applied, the coating film is heated at a temperature of preferably from 80 to 450°C. The film thus formed has a thickness of generally from 1 to 500 nm, preferably from 10 to 200 nm.

This coating fluid for metal oxide film formation should function to fill a trench mask pattern formed in the organic dielectric film and to form a flat surface. Although an antireflection film is formed on this metal oxide film and a photoresist is further applied thereon for photolithography, it is possible to impart a reflection-preventive function to the metal oxide film and thereby omit the step of forming an antireflection film.

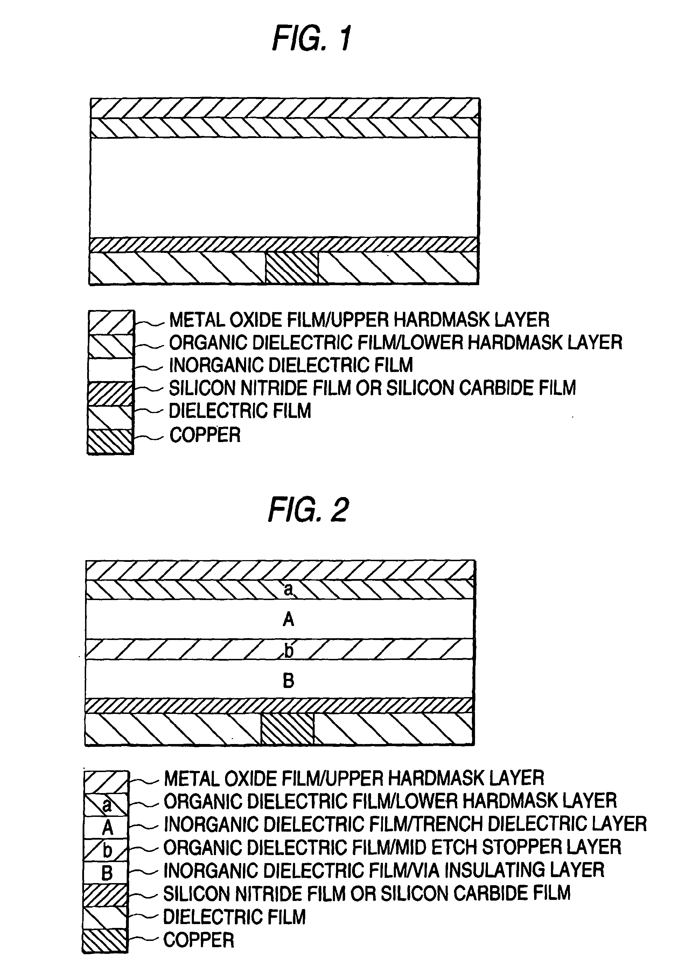

A typical example of the method of dual damascene structure formation is as follows.
1. Step of forming multilayer structure
   An inorganic dielectric film, an organic dielectric film and a metal oxide film are formed on a substrate on which a dual damascene structure is to be formed, whereby the multilayer structure shown in Fig. 1 is obtained.
   When the coating operation is conducted as laid out in claim 1 so as to superpose an inorganic dielectric film, organic dielectric film, inorganic dielectric film, organic dielectric film, and metal oxide film in this order, then an inorganic dielectric film having a mid etch stopper layer therein can be formed as shown in Fig. 2.
2. Step of forming trench pattern by photolithography
3. Step of trench pattern transfer to metal oxide film
4. Step of trench pattern transfer to organic dielectric film
5. Step of filling trenches of organic dielectric film trench pattern mask and planarization with metal oxide film
6. Step of forming via pattern by photolithography
7. Step of via pattern transfer to trench layer
8. Step of via pattern transfer to mid etch stopper
9. Step of via formation
10. Step of trench formation
11. Step of breaking copper barrier layer (silicon carbide or silicon nitride film formed by CVD); step of depositing barrier metal and copper wiring and filling
12. Step of copper polishing with CMP slurry

Step 4, in which a trench pattern is transferred to the organic dielectric film, combines two steps, i.e., the etching of the organic dielectric film according to a trench mask pattern and the ashing of the photoresist.

Forming a metal oxide film beforehand on the organic dielectric film for step 4 is preferred in that the metal oxide film functions as a stopper film during the photoresist ashing and, hence, the processing can be conducted without the necessity of taking account of the etching selective ratio between the organic dielectric film and the photoresist pattern.

In step 7, the metal oxide film is preferably a silica film because this metal oxide film and the inorganic dielectric film can be successively etched without necessitating a considerable change in gas composition.

In step 8, the via pattern is transferred to the organic dielectric film functioning as a mid etch stopper.

The mid etch stopper is useful because the necessity of strictly matching all the control parameters can be eliminated therewith.

In step 9, the trench layer is etched. As the etching of the lower via layer proceeds, the metal oxide film is completely removed and the trench mask of the organic dielectric film underlying the metal oxide film appears. By transferring this trench mask pattern to the inorganic dielectric film as a trench layer, a dual damascene structure can be formed. The organic dielectric film preferably functions as a CMP stopper for copper CMP in step 12.

A dry etching process employing a fluorocarbon gas as the main component is generally used for the etching of the inorganic dielectric film and the metal oxide film.

For the etching of the organic dielectric film and the ashing of the photoresists, use is made of a dry etching process employing an oxygen plasma, ammonia plasma, hydrogen/nitrogen mixed gas plasma, or nitrogen/oxygen mixed gas as the main component.

The invention will be explained below in more detail by reference to the following Example. However, the following description merely shows a general embodiment example of the invention, and it should be understood that the invention is set out in the claims and not construed as being limited by the description.

In the following Synthesis Examples and Example, all "parts" and "percents" are by weight unless otherwise indicated.

### SYNTHESIS EXAMPLE 1

### Preparation of Coating Fluid for Inorganic Dielectric film

To a solution prepared by mixing 5 g of 25% ammonia water, 320 g of ultrapure water and 600 g of ethanol were added 15 g of methyltrimethoxysilane (7.4 g in terms of the product of complete hydrolysis and condensation) and 20 g of tetraethoxysilane (5.8 g in terms of the product of complete hydrolysis and condensation). This mixture was reacted at 60°C for 3 hours. Maleic acid was added to the resulting reaction mixture to adjust the pH thereof to 2.5. To this solution was added 150 g of propylene glycol monopropyl ether. The resulting mixture was concentrated under reduced pressure to obtain a composition solution having a solid content of 9%.

### SYNTHESIS EXAMPLE 2

### Preparation of Coating Fluid for Organic Dielectric film

Into a flask were introduced 37.8 g of 9,9-bis(4-hydroxy-3-methylphenyl)fluorene and 37.8 g of potassium carbonate together with 350 g of dimethylacetamide. The contents were heated at 150°C for 2 hours in a nitrogen atmosphere while removing the resulting water vapor from the system. To this solution was added 21.8 g of bis (4-fluorophenyl) ketone. The resulting mixture was reacted at 165°C for 10 hours, subsequently cooled, and then filtered to remove the insoluble matter contained in the solution. Reprecipitation was conducted from methanol. This precipitate was sufficiently washed with ion-exchanged water and then dissolved in cyclohexanone. After the insoluble matter was removed, the solution was poured into methanol to conduct reprecipitation. This precipitate was dried in a 60°C vacuum oven for 24 hours to obtain a polymer.

In 18 g of cyclohexanone was dissolved 2 g of the polymer. This solution was filtered through a polytetrafluoroethylene (Teflon) filter having a pore diameter of 0.2 µm to obtain a coating fluid for an organic dielectric film.

### SYNTHESIS EXAMPLE 3

### Preparation of Coating Fluid for Metal Oxide Film Formation

(1) In 298 g of propylene glycol monopropyl ether was dissolved 106.4 g of tetramethoxysilane. This solution was stirred with a Three-One Motor to keep the solution temperature at 60°C. Subsequently, 50 g of ion-exchanged water containing 2.1 g of maleic acid dissolved therein was added to the solution over 1 hour. Thereafter, the reaction mixture was reacted at 60°C for 4 hours and then cooled to room temperature. A solution containing methanol was removed in an amount of 90 g from the reaction mixture at 50°C by evaporation, and 643 g of propylene glycol monopropyl ether was added to the residue to obtain a solution (A).
(2) To the solution (A) was added 5 g of bis(4-t-butylphenyl)iodonium camphorsulfonate as ingredient (B). The resulting mixture was filtered through a Teflon filter having a pore diameter of 0.2 µm to obtain a coating fluid for metal oxide film formation.

### EXAMPLE 1

(1) A silicon nitride film having a thickness of 400 nm was formed on a silicon substrate by ordinary plasma CVD. The coating fluid for inorganic dielectric film formation prepared in Synthesis Example 1 was applied to the coated substrate by spin coating, and this substrate was heated first in the air at 80°C for 5 minutes and subsequently in nitrogen at 200°C for 5 minutes and then heated under vacuum at 425°C for 1 hour to thereby form a via insulating layer (A) composed of an inorganic dielectric film having a thickness of 300 nm.
   The via insulating layer formed was subjected to a UV/ozone treatment to activate the surface thereof. Thereafter, the coating fluid for organic dielectric film formation prepared in Synthesis Example 2 was applied thereto by spin coating. This substrate was dried first at 80°C for 1 minute and subsequently at 200°C for 2 minutes and then further heated in a 450°C nitrogen atmosphere for 5 minutes to thereby form a mid etch stopper layer (B) having a thickness of 50 nm.
   The coating fluid (1) for inorganic dielectric film formation obtained in Synthesis Example 1 was applied to the mid etch stopper layer and then dried in the same manner as in the formation of the via insulating layer to thereby form a trench insulating layer (C) having a thickness of 300 nm. The trench insulating layer (C) was subjected to a UV/ozone treatment to activate the surface thereof. Thereafter, the coating fluid for organic dielectric film formation was applied and dried in the same manner as in the formation of the mid etch stopper layer (B) to thereby form a lower hardmask layer (D) having a thickness of 100 nm. The coating fluid for metal oxide film formation prepared in Synthesis Example 3 was then applied by spin coating and then dried with a 200°C hot plate for 2 minutes to thereby form an upper hardmask layer (E) having a thickness of 30 nm.
(2) Subsequently, a KrF positive photoresist was used to form a 0.35 µm trench pattern resist mask on the upper hardmask layer (E). Thereafter, the trench pattern was transferred to the upper hardmask layer (E) with a fluorocarbon-based dry etching gas.
(3) The trench pattern was further transferred to the lower hardmask layer (D) with an NH₃ gas plasma.
(4) The residue of the trench pattern resist mask was removed with a wet cleaning liquid (pH=8).
(5) Subsequently, the coating fluid for metal oxide film formation prepared in Synthesis Example 3 was applied to the trench pattern-bearing upper hardmask layer so as to result in a film thickness of 50 nm and heated in the same manner as in (1) above to thereby form an upper hardmask layer (E').
(6) A KrF positive photoresist was used to form a 0.25-µm hole pattern resist mask on the upper hardmask layer (E').
(7) Using a fluorocarbon-based dry etching gas, this hole pattern was transferred to the upper hardmask (E) and further to the trench insulating layer (C) to expose the mid etch stopper layer (B).
(8) Subsequently, the hole pattern was transferred to the mid etch stopper layer (B) with an NH₃ gas plasma.
(9) A fluorocarbon-based dry etching gas was used once again to conduct hole formation in the via layer (A) and, simultaneously therewith, remove the upper hardmask (E). Subsequently, the etching gas was shifted to another fluorocarbon-based dry etching gas to form trenches in the trench layer (C).
(10) Finally, the lower silicon nitride film was broken with a fluorocarbon-based dry etching gas to complete trench and hole formation.
(11) The trenches and holes were rinsed with a wet cleaning liquid (pH 8) to remove the deposits attributable to the etching gases. Tantalum was deposited by PVD to form a barrier metal layer having a thickness of 1 nm. Furthermore, a copper seed layer was formed by PVD, and the holes and trenches were filled with a copper wire by plating.
(12) That part of the copper which was overlaid on the barrier metal layer was removed by CMP and the barrier metal as the uppermost layer was also removed. Thus, the formation of a copper dual damascene wiring was completed.
(13) A section of the wafer was examined with a scanning electron microscope. It was ascertained that a copper dual damascene wiring had been formed without fail.

According to the invention which has the constitution described above, the problem concerning etching selective ratio associated with the use of a combination of CVD films selected from silicon carbide, silicon nitride and silica films can be eliminated. The invention further has a merit that most of the constituent layers including insulating layers and hardmasks can be formed from coating materials and, hence, the process flow can be simplified.

## Claims

1. A method of forming a dual damascene structure, which comprises:
i) preparing a siloxane-based dielectric film (B) having a dielectric constant ranging from 1.5 to 3.2 and then superposing an organic dielectric film (b) on a surface of the siloxane-based dielectric film, the resulting bilayer structure, upon subsequent etching of the completed dual damascene structure, confining a via region in the dual damascene structure;
ii) superposing a siloxane-based dielectric film (A) having a dielectric constant ranging from 1.5 to 3.2 on the organic film (b);
iii) superposing an organic dielectric film (a) on the siloxane-based dielectric film (A), the resulting bilayer structure of dielectric film (A) and organic film (b), upon subsequent etching of the completed dual damascene structure, confining a trench region in the dual damascene structure; and
iv) superposing a layer of a metal oxide comprising at least one metal selected from the group consisting of aluminum, gallium, indium, thallium, silicon, germanium, tin, lead, titanium, zirconium, hafnium, vanadium, niobium, tantalum, chromium, molybdenum, tungsten, manganese, zinc, cadmium, arsenic, antimony, bismuth and cerium on the organic dielectric film (a).

2. The method of forming a dual damascene structure of claim 1, wherein the organic dielectric film is a mid etch stopper layer.

3. The method of forming a dual damascene structure of claim 1, wherein the siloxane-based dielectric film having a dielectric constant ranging from 1.5 to 3.2 has hydrocarbon groups.

4. The method of forming a dual damascene structure of claim 1, wherein the resin of the organic dielectric film (b) is an organic polymer selected from the group consisting of polyarylenes, poly(arylene ether)s, polybenzoxazoles and polyimides.

5. The method of forming a dual damascene structure of claim 1, wherein the layer of a metal oxide comprising at least one metal selected from the group consisting of aluminum, gallium, indium, thallium, silicon, germanium, tin, lead, titanium, zirconium, hafnium, vanadium, niobium, tantalum, chromium, molybdenum, tungsten, manganese, zinc, cadmium, arsenic, antimony, bismuth and cerium has a reflectionpreventive function.

6. The method of forming a dual damascene structure of claim 1, wherein the siloxane-based dielectric film is formed by applying a coating fluid comprising a polysiloxane and an organic solvent, and then heating the coated layer.

7. The method of forming a dual damascene structure of claim 1, wherein the organic dielectric film is formed by applying a coating fluid comprising an organic polymer having a glass transition point of 400°C or higher and a heat decomposition temperature of 500°C or higher and an organic solvent, and then heating the coated layer.

8. The method of forming a dual damascene structure of claim 1, wherein the layer of a metal oxide comprising at least one metal selected from the group consisting of aluminum, gallium, indium, thallium, silicon, germanium, tin, lead, titanium, zirconium, hafnium, vanadium, niobium, tantalum, chromium, molybdenum, tungsten, manganese, zinc, cadmium, arsenic, antimony, bismuth and cerium is formed by applying a coating fluid comprising an organic solvent and a compound obtained by hydrolyzing and condensing an alkoxide of at least one metal selected from the group consisting of aluminum, gallium, indium, thallium, silicon, germanium, tin, lead, titanium, zirconium, hafnium, vanadium, niobium, tantalum, chromium, molybdenum, tungsten, manganese, zinc, cadmium, arsenic, antimony, bismuth and cerium; and then heating the coated layer.

9. The method of forming a dual damascene structure of claim 1, wherein the organic dielectric film (a) has a dielectric constant of no more than 4.0.

10. The method of forming a dual damascene structure of claim 1, wherein the organic dielectric film (a) or (b) is coated to a thickness of 10 to 2,000 nm.

11. The method of forming a dual damascene structure of claim 1, wherein the siloxane-based dielectric film (A) or (B) is formed from a polysiloxane prepared by hydrolyzing and condensing at least one silane compound selected from the group consisting of compounds of formulas (1), (2) and (3):
RₐSi (OR¹)₄₋ₐ (1)
wherein R is hydrogen, fluorine or a monovalent organic group; R¹ is a monovalent organic group; and a is an integer of 1 or 2;
Si (OR²)₄ (2)
wherein R² is a monovalent organic group; and
R³ _{b}(R⁴O)_{3-b}Si-(R⁷)_{d}-Si (OR⁵)_{3-c}R⁶ _{c} (3)
wherein R³ to R⁶ are the same or different and each is a monovalent organic group; b and c are the same or different and each is a number of 0 to 2; R⁷ is oxygen, a phenylene group or a group of the formula -(CH₂)ₙ-, wherein n is an integer of 1 to 6; and d is 0 or 1.

## Patentansprüche

1. Verfahren zur Bildung einer dual-Damaststruktur, welches enthält:
(i) Anfertigen eines siloxanbasierten dielektrischen Films (B) mit einer Dielektrizitätskonstante, reichend von 1,5 bis 3,2, und dann Überlagern eines organischen dielektrischen Films (b) auf eine Oberfläche des siloxanbasierten dielektrischen Films, wobei die resultierende Doppelschichtstruktur, nach anschließendem Ätzen der fertigen dual-Damaststruktur, einen Durchgangslochbereich in der dual-Damaststruktur begrenzt;
(ii) Überlagern eines siloxanbasierten dielektrischen Films (A) mit einer Dielektrizitätskonstante, reichend von 1,5 bis 3,2 auf den organischen Film (b);
(iii) Überlagern eines organischen dielektrischen Films (a) auf den siloxanbasierten dielektrischen Film (A), wobei die resultierende Doppelschichtstruktur aus dielektrischem Film (A) und organischem Film (b), nach anschließendem Ätzen der fertigen dual-Damaststruktur, eine Grabenregion in der dual-Damaststruktur begrenzt; und
(iv) Überlagern einer Schicht aus einem Metalloxid, enthaltend zumindest ein Metall ausgewählt aus der Gruppe bestehend aus Aluminium, Gallium, Indium, Thallium, Silizium, Germanium, Zinn, Blei, Titan, Zirkonium, Hafnium, Vanadium, Niob, Tantal, Chrom, Molybdän, Wolfram, Mangan, Zink, Cadmium, Arsen, Antimon, Bismut, und Cer auf den organischen dielektrischen Film (a).

2. Verfahren zur Bildung einer dual-Damaststruktur nach Anspruch 1, wobei der organische dielektrische Film eine Mittelätzstoppschicht ist.

3. Verfahren zur Bildung einer dual-Damaststruktur nach Anspruch 1, wobei der siloxanbasierte dielektrische Film mit einer Dielektrizitätskonstante, reichend von 1,5 bis 3,2, Kohlenwasserstoffgruppen hat.

4. Verfahren zur Bildung einer dual-Damaststruktur nach Anspruch 1, wobei das Harz des organischen dielektrischen Films (b) ein organisches Polymer ist, ausgewählt aus der Gruppe bestehend aus Polyarylenen, Poly(Arylenether)n, Polybenzoxazolen und Polyimiden.

5. Verfahren zur Bildung einer dual-Damaststruktur nach Anspruch 1, wobei die Schicht aus einem Metalloxid, enthaltend zumindest ein Metall ausgewählt aus der Gruppe bestehend aus Aluminium, Gallium, Indium, Thallium, Silizium, Germanium, Zinn, Blei, Titan, Zirkonium, Hafnium, Vanadium, Niob, Tantal, Chrom, Molybdän, Wolfram, Mangan, Zink, Cadmium, Arsen, Antimon, Bismut, und Cer eine reflexionspräventive Funktion hat.

6. Verfahren zur Bildung einer dual-Damaststruktur nach Anspruch 1, wobei der siloxanbasierte dielektrische Film gebildet wird durch Anwendung einer Beschichtungsflüssigkeit, enthaltend ein Polysiloxan und ein organisches Lösungsmittel, und dann Erhitzen der beschichteten Schicht.

7. Verfahren zur Bildung einer dual-Damaststruktur nach Anspruch 1, wobei der organische dielektrische Film gebildet wird durch Anwendung einer Beschichtungsflüssigkeit, enthaltend ein organisches Polymer mit einem Glasübergangspunkt von 400°C oder höher und einer Wärmezersetzungstemperatur von 500°C oder höher und ein organisches Lösungsmittel, und dann Erhitzen der beschichteten Schicht.

8. Verfahren zur Bildung einer dual-Damaststruktur nach Anspruch 1, wobei die Schicht aus einem Metalloxid, enthaltend zumindest ein Metall ausgewählt aus der Gruppe bestehend aus Aluminium, Gallium, Indium, Thallium, Silizium, Germanium, Zinn, Blei, Titan, Zirkonium, Hafnium, Vanadium, Niob, Tantal, Chrom, Molybdän, Wolfram, Mangan, Zink, Cadmium, Arsen, Antimon, Bismut, und Cer gebildet wird durch Anwendung einer Beschichtungsflüssigkeit, enthaltend ein organisches Lösungsmittel und eine Verbindung, erhalten durch Hydrolysierung und Kondensierung eines Alkoxids zumindest eines Metalls ausgewählt aus der Gruppe bestehend aus Aluminium, Gallium, Indium, Thallium, Silizium, Germanium, Zinn, Blei, Titan, Zirkonium, Hafnium, Vanadium, Niob, Tantal, Chrom, Molybdän, Wolfram, Mangan, Zink, Cadmium, Arsen, Antimon, Bismut, und Cer; und dann Erhitzen der beschichteten Schicht.

9. Verfahren zur Bildung einer dual-Damaststruktur nach Anspruch 1, wobei der organische dielektrische Film (a) eine Dielektrizitätskonstante von nicht mehr als 4,0 hat.

10. Verfahren zur Bildung einer dual-Damaststruktur nach Anspruch 1, wobei der organische dielektrische Film (a) oder (b) beschichtet ist zu einer Dicke von 10 bis 2.000 nm.

11. Verfahren zur Bildung einer dual-Damaststruktur nach Anspruch 1, wobei der siloxanbasierte dielektrische Film (A) oder (B) gebildet ist aus einem Polysiloxan, angefertigt durch Hydrolysierung und Kondensierung zumindest einer Silanverbindung, ausgewählt aus der Gruppe bestehend aus Verbindungen der Formeln (1), (2) und (3):
RₐSi (OR¹)₄₋ₐ (1)
wobei R ist Wasserstoff, Fluor oder eine monovalente organische Gruppe; R¹ ist eine monovalente organische Gruppe; und a ist eine ganze Zahl von 1 oder 2;
Si(OR²)₄ (2)
wobei R² eine monovalente organische Gruppe ist; und
R³ _{b}(R⁴O)_{3-b}Si-(R⁷)_{d}-Si (OR⁵)_{3-c}R⁶ _{c} (3)
wobei R³ bis R⁶ gleich oder unterschiedlich sind und jedes eine monovalente organische Gruppe ist; b und c gleich oder unterschiedlich sind und jedes eine Zahl von 0 bis 2 ist; R⁷ ist Sauerstoff, eine Phenylengruppe oder eine Gruppe der Formel -(CH₂)ₙ-, wobei n eine ganze Zahl von 1 bis 6 ist; und d ist 0 oder 1.

## Revendications

1. Procédé de formation d'une structure dual damascène, qui comprend :
i) préparer un film diélectrique à base de siloxane (B) ayant une constante diélectrique allant de 1,5 à 3,2 puis superposer un film diélectrique organique (b) sur une surface du film diélectrique à base de siloxane, la structure bicouche résultante, lors de la gravure subséquente de la structure dual damascène achevée, confinant une région de via dans la structure dual damascène ;
ii) superposer un film diélectrique à base de siloxane (A) ayant une constante diélectrique allant de 1,5 à 3,2 sur le film organique (b) ;
iii) superposer un film diélectrique organique (a) sur le film diélectrique à base de siloxane (A), la structure bicouche résultante de film diélectrique (A) et de film organique (b), lors de la gravure subséquente de la structure dual damascène achevée, confinant une région de tranchée dans la structure dual damascène ; et
iv) superposer une couche d'un oxyde métallique comprenant au moins un métal choisi dans le groupe consistant en l'aluminium, le gallium, l'indium, le thallium, le silicium, le germanium, l'étain, le plomb, le titane, le zirconium, le hafnium, le vanadium, le niobium, le tantale, le chrome, le molybdène, le tungstène, le manganèse, le zinc, le cadmium, l'arsenic, l'antimoine, le bismuth et le cérium sur le film diélectrique organique (a).

2. Procédé de formation d'une structure dual damascène selon la revendication 1, où le film diélectrique organique est une couche d'arrêt de gravure moyenne.

3. Procédé de formation d'une structure dual damascène selon la revendication 1, où le film diélectrique à base de siloxane ayant une constante diélectrique allant de 1,5 à 3,2 a des groupes hydrocarbonés.

4. Procédé de formation d'une structure dual damascène selon la revendication 1, où la résine du film diélectrique organique (b) est un polymère organique choisi dans le groupe consistant en les polyarylènes, les poly(arylène éther)s, les polybenzoxazoles et les polyimides.

5. Procédé de formation d'une structure dual damascène selon la revendication 1, où la couche d'un oxyde métallique comprenant au moins un métal choisi dans le groupe consistant en l'aluminium, le gallium, l'indium, le thallium, le silicium, le germanium, l'étain, le plomb, le titane, le zirconium, le hafnium, le vanadium, le niobium, le tantale, le chrome, le molybdène, le tungstène, le manganèse, le zinc, le cadmium, l'arsenic, l'antimoine, le bismuth et le cérium a une fonction empêchant la réflection.

6. Procédé de formation d'une structure dual damascène selon la revendication 1, où le film diélectrique à base de siloxane est formé par application d'un fluide de couchage comprenant un polysiloxane et un solvant organique puis chauffage de la couche appliquée par couchage.

7. Procédé de formation d'une structure dual damascène selon la revendication 1, où le film diélectrique organique est formé par application d'un fluide de couchage comprenant un polymère organique ayant un point de transition vitreuse de 400°C ou plus et une température de décomposition thermique de 500°C ou plus et un solvant organique, puis chauffage de la couche appliquée par couchage.

8. Procédé de formation d'une structure dual damascène selon la revendication 1, où la couche d'un oxyde métallique comprenant au moins un métal choisi dans le groupe consistant en l'aluminium, le gallium, l'indium, le thallium, le silicium, le germanium, l'étain, le plomb, le titane, le zirconium, le hafnium, le vanadium, le niobium, le tantale, le chrome, le molybdène, le tungstène, le manganèse, le zinc, le cadmium, l'arsenic, l'antimoine, le bismuth et le cérium est formée par application d'un fluide de couchage comprenant un solvant organique et un composé obtenu par hydrolyse et condensation d'un alcoolate d'au moins un métal choisi dans le groupe consistant en l'aluminium, le gallium, l'indium, le thallium, le silicium, le germanium, l'étain, le plomb, le titane, le zirconium, le hafnium, le vanadium, le niobium, le tantale, le chrome, le molybdène, le tungstène, le manganèse, le zinc, le cadmium, l'arsenic, l'antimoine, le bismuth et le cérium ; puis chauffage de la couche appliquée par couchage.

9. Procédé de formation d'une structure dual damascène selon la revendication 1, où le film diélectrique organique (a) a une constante diélectrique d'au plus 4,0.

10. Procédé de formation d'une structure dual damascène selon la revendication 1, où le film diélectrique organique (a) ou (b) est appliqué par couchage en une épaisseur de 10 à 2 000 nm.

11. Procédé de formation d'une structure dual damascène selon la revendication 1, où le film diélectrique à base de siloxane (A) ou (B) est formé à partir d'un polysiloxane préparé par hydrolyse et condensation d'au moins un composé silane choisi dans le groupe consistant en les composés des formules (1), (2) et (3) :
RₐSi (OR¹)₄₋ₐ (1)
où R est l'hydrogène, le fluor ou un groupe organique monovalent ; R¹ est un groupe organique monovalent ; et a est un entier de 1 ou 2 ;
Si (OR²)₄ (2)
où R² est un groupe organique monovalent ; et
R³ _{b}(R⁴O)_{3-b}Si-(R⁷)_{d}-Si(OR⁵)_{3-c}R⁶ _{c} (3)
où R³ à R⁶ sont identiques ou différents et sont chacun un groupe organique monovalent ; b et c sont identiques ou différents et sont chacun un nombre de 0 à 2 ; R⁷ est l'oxygène, un groupe phénylène ou un groupe de formule -(CH₂)ₙ-, où n est un entier de 1 à 6 ; et d est 0 ou 1.
